Europäisches Patentamt

European Patent Office

Office européen des brevets

(19)

(11) EP 0 264 283 B1

(12) **EUROPEAN PATENT SPECIFICATION**

(45) Date of publication and mention
of the grant of the patent:
**10.09.1997 Bulletin 1997/37**

(51) Int Cl.6: **H01L 21/82**

(21) Application number: 87309125.0

(22) Date of filing: **15.10.1987**

(54) **Method of fabricating a complementary MOS integrated circuit device**

Verfahren zur Herstellung einer komplementären MOS integrierten Schaltungsanordnung

Methode de fabrication d'un dispositif de circuit intégré MOS complémentaire

(84) Designated Contracting States:
**DE FR GB IT NL**

(30) Priority: **17.10.1986 JP 246811/86**

(43) Date of publication of application:
**20.04.1988 Bulletin 1988/16**

(73) Proprietor: **CANON KABUSHIKI KAISHA**
**Tokyo (JP)**

(72) Inventors:
  • **Ozaki, Masaharu**
    **Yokohama-shi Kanagawa-ken (JP)**
  • **Yonehara, Takao**
    **Atsugi-shi Kanagawa-ken (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**EP-A- 0 252 757        US-A- 3 620 833**

• **JOURNAL OF THE ELECTROCHEMICAL
  SOCIETY, vol. 133, no. 6, June 1986, pages 1274-
  1275, Manchester, NH, US; R.P. ZINGG et al.:
  "Epitaxial lateral overgrowth of silicon over
  steps of thick SiO2"**
• **JOURNAL OF THE ELECTROCHEMICAL
  SOCIETY, vol. 128, no. 6, June 1981, pages 1353-
  1359, Princeton, New Jersey, US; W.A.P.
  CLAASSEN et al.: "The nucleation of CVD silicon
  on SiO2 and Si3N4 substrates"**
• **JAPANESE JOURNAL OF APPLIED PHYSICS,
  supplements, 17th conference on solid state
  devices and materials, Tokyo, 25th-27th August
  1985, pages 143-146; M. OHKURA et al.:
  "Orientation controlled SOI by line-shaped
  laser-beam seeded lateral epitaxy for CMOS
  stacking"**
• **Philips Technical review, vol. 41 (1983/84), no. 2,
  Eindhoven, Nederland, pp. 60-69**
• **Mat. Res. Soc. Symp. Proc., vol. 106 (1988), pp
  21-26**

## Description

The present invention relates to a method of fabricating a complementary MOS integrated circuit device and, more particularly, a complementary MOS integrated circuit device having an MOS transistor of one channel conductivity type formed on a semiconductor substrate and an MOS transistor of complementary channel conductivity type formed thereon and separated therefrom by an electrically insulative layer.

Hitherto, in a complementary MOS integrated circuit device, in general, on a silicon monocystalline substrate (hereinafter, referred to as a silicon substrate) of the first conductivity type, a diffusion layer of the second conductivity type opposite to the first conductivity type of the silicon substrate is partially formed, an MOS transistor of the first conductivity type is formed on the diffusion layer of the second conductivity type, and an MOS transistor of the second conductivity type is formed on the silicon substrate of the first conductivity type.

An example of a constitution of such a conventional complementary MOS integrated circuit device will be explained. When an N-type silicon substrate is used, a first P-type diffusion layer called a P well is formed in the N-type silicon substrate and thereafter, a second P-type diffusion layer serving as drain/source of the P channel MOS transistor is formed in the N-type silicon substrate, and a first N-type diffusion layer serving as drain/source of an N channel MOS transistor is formed in the first P-type diffusion layer.

The foregoing complementary MOS integrated circuit device has a serious problem such that a latch-up occurs because a thyristor is constituted by a parasitic bipolar transistor which is formed due to the constitution of this device. In addition, this device has a problem such that a degree of integration is small since both of the P channel MOS transistor and the N channel MOS transistor are two-dimensionally laterally arranged. Various studies and improvements have been made to solve such problems. As one of them, there has been proposed a method whereby an N channel MOS transistor is formed on a P-type silicon substrate and thereafter, the N channel MOS transistor is covered by an insulative layer, a P channel MOS transistor is formed on a thin film formed on the insulative layer, and a complementary MOS integrated circuit of a multi-layer is formed. However, in the conventional thin film forming technique, in general, only a thin film of amorphous silicon or polysilicon can be grown on the insulative layer. Therefore, hitherto, there is used a method whereby a P channel MOS transistor is formed on a polysilicon thin film or a silicon thin film which has once grown is melted by a laser beam or the like so as to form a monocrystal.

However, the foregoing methods also have the following problems.

First, the method whereby the P channel MOS transistor is formed on the polysilicon thin film has a problem such that the channel mobility is remarkably smaller than that in the case where it was formed on a monocrystal. On the other hand, according to the method whereby the silicon thin film is melted to form a monocrystal, after an N channel MOS transistor was formed on the silicon substrate, the silicon thin film is melted. Thus, the temperature of the N channel MOS transistor rises and impurities are redistributed in the diffusion layer which has once been formed. Such a redistribution of the impurities which occurs after the N channel MOS transistor was formed causes the characteristic to remarkably deteriorate and becomes a serious problem in the fine MOS transistor which has recently been realized.

The problem just mentioned has been addressed by M Ohkura et al "Orientation Control SOI By Line Shape Laser Beam Seeded Lateral Expitaxy For CMOS Stacking", Japanese Journal of Applied Physics, Supplements, 17th Conference on Solid State Devices and Materials, Tokyo, August 1985, pages 143 to 146. As disclosed a stacked CMOS structure is formed by MOS transistors formed in successive isolated monocrystalline layers. These layers are produced from polysilicon layers upon recrystallisation using a line shaped laser beam and an optimised capping layer. In this process only slight melting is needed for crystal growth and as a consequence the lateral diffusion of impurities from the seeding region is substantially suppressed.

The method as defined hereinbelow is intended as an alternative to this process.

In accordance with the present invention, there is provided a method of fabricating a complementary MOS transistor which method comprises:-

providing a monocrystalline silicon semiconductor substrate having a first MOS transistor of a first channel conductivity type defined at the surface thereof, which transistor is isolated by a surrounding region of field oxide;
covering said first MOS transistor with a layer of silicon dioxide;
producing a silicon monocrystal on said layer of silicon dioxide; and
producing a second MOS transistor of a second and complementary channel conductivity type at the surface of said silicon monocrystal;

characterised in that to produce said silicon monocrystal the following steps are performed:

producing a nucleation site of size a few um or less consisting of silicon nitride, silicon oxynitride or tantalum oxide on said layer of silicon dioxide or consisting of a region of said layer of silicon dioxide implanted with ions of nitrogen or excess ions of silicon; and
depositing silicon thereby growing a single nucleus of silicon selectively on said nucleation site, and growing said silicon monocrystal from said single nucleus.

The CMOS integrated circuit device produced by this method is of stacked construction and latch-up is prevented. This method is suited to producing devices having high component integration and can be performed so that the monocrystalline material produced exhibits high carrier mobility and accordingly performance can be improved by a remarkable degree.

Single crystal material grown in this manner exhibits hardly any crystal lattice defects and substantially no grain boundaries. Diffusion of aluminium or other wiring electrode material and diffusion of other impurities present during the processing, therefore, is substantially eliminated.

This method also is versatile in that it is not limited to any particular MOS device process.

Mention is made of European Patent Application EP-A-0252757 of Canon Kabushiki Kaisha with reference to Article 54(3) EPC. This also discloses a method in which the epitaxial growth of single crystal material is preceded by a step of selective deposition and single nucleus formation. The above mentioned patent application concerns the fabrication of a photoelectric conversion device, a device which is of multi-layer integrated circuit construction. In the construction described, bipolar transistors, MOS transistors and photodiodes are formed in successive single crystal layers. The transistor and photodiode components are stacked vertically. MOS transistors and photodiodes are inter-connected via through holes in a separating electrically insulative layer. The above mentioned patent application, however, does not address the problems of CMOS integrated circuit construction.

The problem of CMOS integrated circuit construction is addressed however in European Patent Application EP-A-0251767 which also is mentioned here with reference to Article 54(3) EPC. Examples of stacked integrated circuits are described and in particular a stacked CMOS circuit is described with reference to and is shown in Figure 18 of that patent application. Each CMOS element is formed of single crystal silicon material grown by a process of selective nucleation and epitaxial growth. The silicon single crystal material at each layer is formed as one or more spaced islands. These islands are on insulator material and further are isolated by a covering of insulator material, specifically silicon oxide. This oxide evidently is deposited and not grown as a field oxide. This is to be contrasted with the present invention in which the or each underlying CMOS circuit element is defined in the surface of a monocrystaline substrate and is isolated by a surrounding region of field oxide.

Mention is also made of the following paper by W A P Claassen et al "The Nucleation of CVD Silicon on SiO$_2$ and Si$_3$N$_4$ Substrates" which is reported on the Journal of the Electrochemical Society, Vol 128, No 6, June 1981, pages 1353 to 1359. This paper is mentioned by way of background only and concerns measurements of the nucleation density of CVD silicon upon separate and not adjacent surfaces of silicon oxide and silicon nitride.

BRIEF DESCRIPTON OF THE DRAWINGS

Fig. 1 is a schematic diagram showing a complementary MOS integrated circui device;

Fig. 2 is a schematic diagram showing a complementary integrated circuit device having a number of N channel MOS transistors and a number of P channel MOS transistors;

Figs. 3(A) and 3(B) are explanatory diagrams of a selective deposition method;

Fig. 4 is a graph showing time-dependent changes of the nucleation densities of a deposition surface of SiO$_2$ and of a deposition surface of silicon nitride;

Figs. 5(A) to 5(D) are forming step diagrams showing an example of a method of forming monocrystal ;

Figs. 6(A) and 6(B) are perspective views of a substrate in Figs. 5(A) and 5(D);

Fig. 7 is a graph showing the relation between the flow rate ratio of SiH$_4$ and NH$_3$ and the composition ratio of Si and N in silicon nitride film forming;

Fig. 8 is a graph showing a relation between Si/N composition ratio and nucleation density; and

Fig. 9 is a graph showing the relation between injection quantity of Si ions and nucleation density.

An embodiment of the present invention will be described in detail hereinbelow with reference to the drawings.

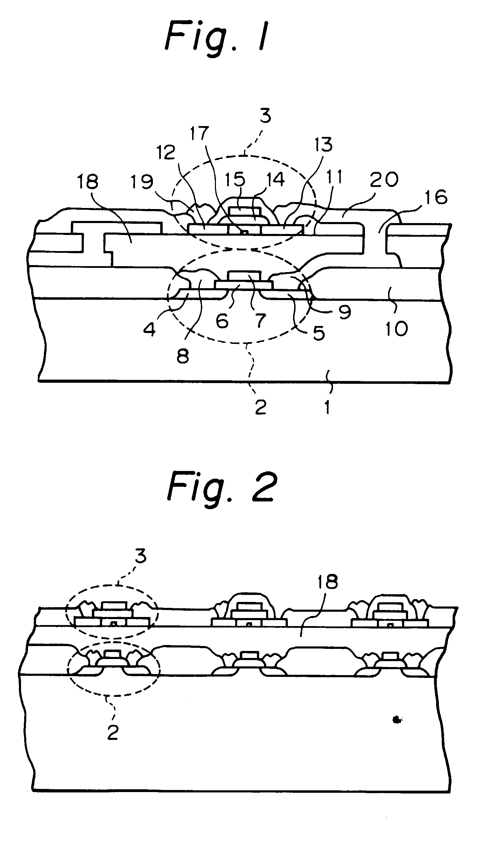

Fig. 1 is a schematic diagram showing a complementary MOS integrated circuit device which can be produced by the method described below.

As shown in the diagram, an N channel MOS transistor 2 is formed on a P-type silicon substrate 1 serving as a semiconductor substrate. The N channel MOS transistors 2 is isolated by a field oxide film 10. A source region 4 and a drain region 5 are formed in the P-type silicon substrate 1. A gate electrode 7 is further formed over the source and drain regions 4 and 5 through a gate insulative layer 6. The source region 4 is connected to wiring 8. The drain region 5 is connected to wiring 9.

A P channel MOS transistor 3 is formed over the N channel MOS transistor 2 and is separated therefrom by a separation layer (18).

The P channel MOS transistor 3 is formed in the following manner. First, a nucleation portion 17 made of a dissimilar material whose nucleation density is sufficiently larger than that of the material of the separate layer 18 is formed on a deposition surface 11 on the separation layer 18. A monocrystalline region (or what is substantially a monocrystalline region) grows around a single nucleus formed in the nucleation portion 17, thereby forming a monocrystalline semiconductor layer (or a substantially monocrystalline semiconductor layer). A source region 12 and a drain region 13 are formed in the monocrystalline semiconductor layer (or substantially monocrystalline semiconductor layer). A gate electrode 15 is further formed above the source and drain regions 12 and 13. This is separated from the transistor channel by a gate insulative layer 14. The source region 12 is connected to wiring 19. The drain region 13 is connected to wiring 20. The wiring 20 is connected to the wiring 19 via a through hole 16.

To summarise, the separation layer 18 is formed on the N channel MOS transistor 2. The monocrystalline semiconductor layer (or substantially monocrystalline semiconductor layer) is formed on the insulative layer 18. The P channel MOS transistor 3 is formed in the monocrystalline semiconductor layer (or substantially monocrystalline semiconductor layer). In this manner, the complementary MOS transistor is constituted. The N channel MOS transistor 2 is formed in the P-type silicon substrate 1. Once the N channel MOS transistor 2 has been formed, it is not subjected to any high temperature treatment. Therefore, as compared with the conventional N channel MOS transistor, the characteristics are not degraded. On the other hand, in the case of the P channel MOS transistor 3, since it is formed in the monocrystalline semiconductor layer (or substantially monocrystalline semiconductor layer), its channel mobility is $200 cm^2/v.s$ or more. The characteristics are almost the same as those of a conventional P channel MOS transistor formed on a monocrystalline wafer.

Fig. 2 is a schematic diagram showing a complementary integrated circuit device having a number of N channel MOS transistors and a number of P channel MOS transistors. This also can be produced by this method.

As shown in the diagram, in a manner similar to the foregoing example, N channel MOS transistors 2 are isolated by field oxide regions 10 and are formed in the P-type silicon substrate 1. The P channel MOS transistors 3 are formed over these and are separated therefrom by a separation layer 18.

In the foregoing structure, the N channel MOS transistor has been formed in a P-type silicon substrate and the P channel MOS transistor has been formed in a monocrystalline semiconductor layer (or substantially monocrystalline semiconductor layer). Alternatively, it is also possible to provide the P channel MOS transistor in an N-type silicon substrate and to provide the N channel MOS transistor in a monocrystalline semiconductor layer (or substantially monocrystalline semiconductor layer).

A method of manufacturing the complementary MOS integrated circuit device will now be described In the following explanation, the method of manufacturing the N channel MOS transistor and the P channel MOS transistor is not detailed since well-known MOS integrated circuit manufacturing techniques can be used. Only the method steps of forming the monocrystalline semiconductor layer (or substantial monocrystalline semiconductor layer) will be described in detail.

Firstly, by way of introduction a selective deposition method of selectively forming a deposition film on the deposition surface will be explained. The selective deposition method is a method whereby a thin film is selectively formed on the substrate by use of the differences between materials with respect to factors such as surface energy, attachment coefficient, peel off coefficient, surface diffusion rate, etc. which influence the formation of a nucleus in the thin film forming process.

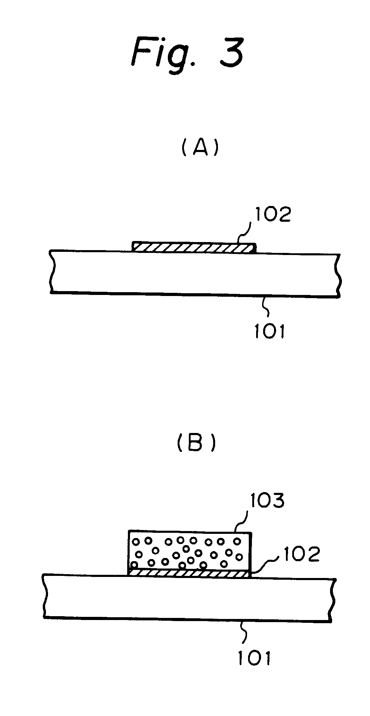

Figs. 3(A) and 3(B) are explanatory diagrams of the selective deposition method.

First, as shown in Fig. 3(A), a thin film 102 is formed at a desired region of a substrate 101. The thin film 102 is made of a material whose factors mentioned above are different from those of the substrate 101. When a thin film made of a proper material is deposited under the proper deposition conditions , it is possible to cause a phenomenon such that a thin film 103 grows only on the thin film 102 and does not grow on the substrate 101. By use of this phenomenon, it is possible to grow a thin film 103 shaped in a self-aligned manner. Lithography processing using a resist, as in the conventional method can be omitted, therefore.

As the materials capable of performing the deposition by such a selective forming method, for example, $SiO_2$ may be used for the substrate 101; $Si_3N_4$ may be used for the thin film 102; and Si may be used for the thin film 103 which is deposited.

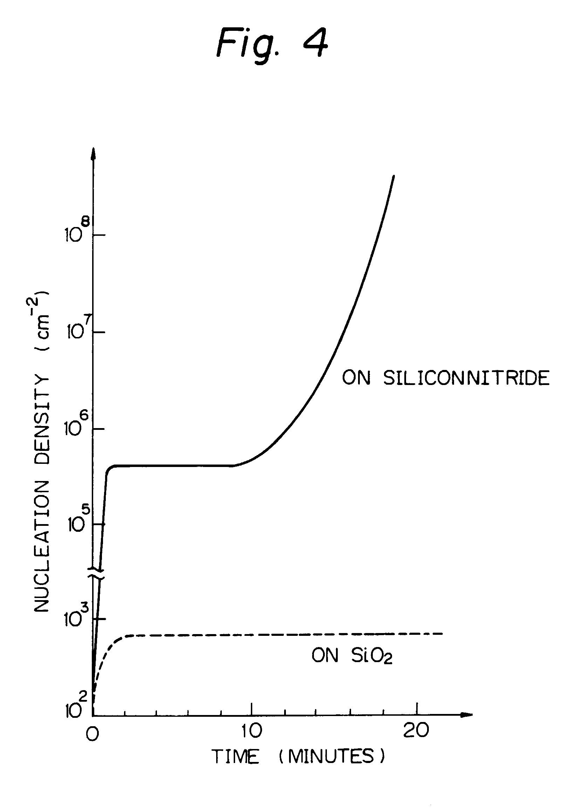

Fig. 4 is a graph showing time-dependent changes of the nucleation densities of a deposition surface of $SiO_2$ and of a deposition surface of silicon nitride.

As shown in-the graph, after deposition is started, the nucleation density on $SiO_2$ is soon saturated at a value of $10^3 cm^{-2}$ or less and its value hardly changes even after the elapse of twenty minutes.

On the other hand, the nucleation density on silicon nitride ($Si_3N_4$) is once saturated at a value of about $4 \times 10^5 cm^{-2}$ and thereafter, it hardly changes for about ten minutes. However, it suddenly increases thereafter. In these measurements

$SiC\ell_4$ gas was diluted by $H_2$ gas and the thin film was deposited by a CVD method under conditions of a pressure of $2.33 \times 10^4$ Pa (175 Torr) and a temperature of 1000°C. The similar function can be also obtained by adjusting the pressure, temperature, and the like by use of the reactive gas such as $SiH_4$, $SiH_2C\ell_2$, $SiHC\ell_3$, $SiF_4$, or the like. In addition, the similar function can be also derived by the vacuum deposition method.

In this case, although the formation of a nucleus on $SiO_2$ hardly causes a problem, by adding the $HC\ell$ gas into the reactive gas, the formation of a nucleus on $SiO_2$ can be further suppressed and the deposition of Si on $SiO_2$ can be perfectly eliminated.

Such a phenomenon is largely influenced by the differences of the attachment coefficient, peel off coefficient, surface diffusion coefficient, etc. of the surfaces of the materials of $SiO_2$ and silicon nitride to Si. However, it can be considered that $SiO_2$ reacts by the Si atom itself and silicon monoxide having a high vapor pressure is produced, so that $SiO_2$ itself is etched and such an etching phenomenon does not occur on silicon nitride, and this fact also results in a cause of the occurrence of the selective deposition (T. Yonehara, S. Yoshioka, S. Miyazawa, "JOURNAL OF APPLIED PHYSICS", Vol. 53, page 6839, in 1982).

In this manner, by selecting $SiO_2$ and Silicon nitride as the materials of the deposition surfaces and by selecting silicon as the material to be deposited, an enough large difference of the nucleation density can be obtained as shown in Fig. 4. Although $SiO_2$ is desirable as the material of the deposition surface, the nucleation density difference can be also obtained by use of $SiO_x$ without limiting to $SiO_2$ as such a material.

Obviously, this method is not limited to the use of these materials. It is sufficient to use a material such that the nucleation density difference is equal to or larger than the value of $10^3$ times as the nucleation density as shown in Fig. 4.

As another method of obtaining the nucleation density difference, regions having surplus ions of Si, N,. may be also formed by locally ion implanting Si, N into $SiO_2$.

By sufficiently finely forming a dissimilar material whose nucleation density is enough larger than that of the materials of the deposition surfaces so that only a single nucleus grows by use of the foregoing selective deposition method, a monocrystal can be selectively grown on only the portion where the fine dissimilar material exists.

Since the selective growth of the monocrystal is determined by the state of electrons on the deposition surface, particularly, by the state of a dangling bond, there is no need to use a bulk material as the material (e.g., $SiO_2$) of a low nucleation density. It is sufficient that such a material is formed on only the surface of an arbitrary material, substrate, or the like and constitutes the deposition surface.

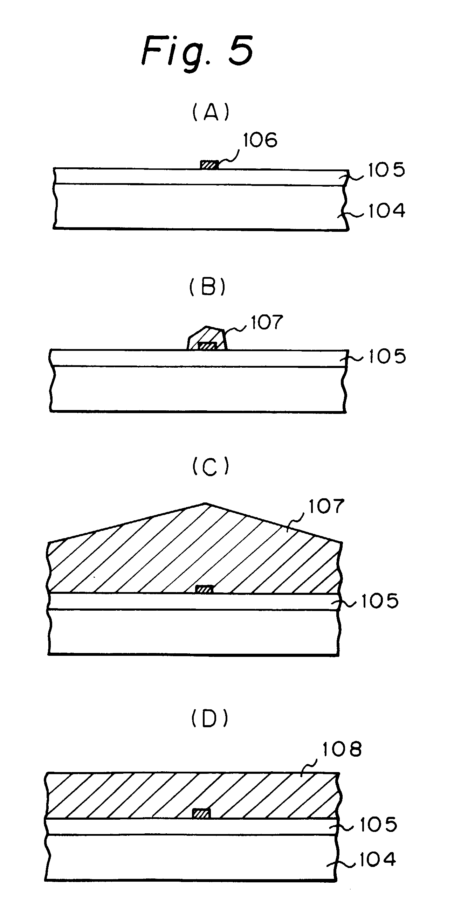

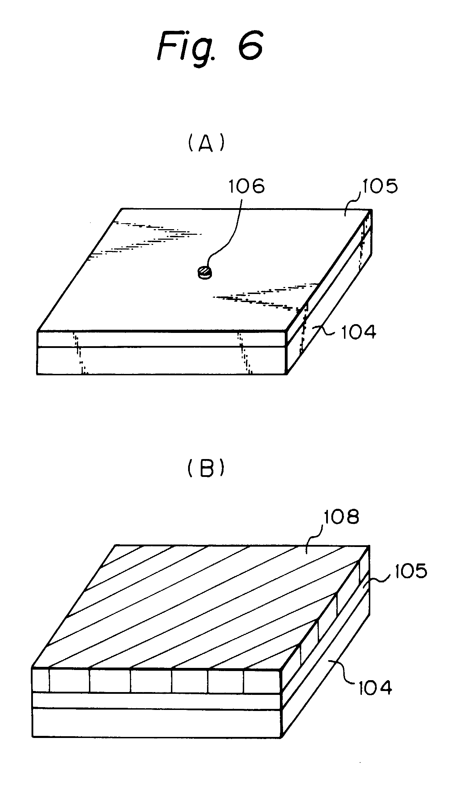

Figs. 5(A) to 5(D) are forming step diagrams showing an example of a method of forming a monocrystal. Figs. 6(A) and 6(B) are perspective views of a substrate in Figs. 5(A) and 5(D).

First, as shown in Figs. 5(A) and 6(A), a thin film 105 of a small nucleation density capable of realizing the selective deposition is formed on a substrate 104. A dissimilar material of a large nucleation density is thinly deposited on the thin film 105 and is patterned by a lithography or the like, thereby sufficiently finely forming a hetero material 106 on the thin film 105. Since the size, crystal structure, and compositions of the substrate 104 can be arbitrarily set, a substrate on which functional devices (specifically one or more MOS transistors) are formed is used as the substrate 104. As mentioned above, as an alternative, the dissimilar material 106 can comprise the modified regions having surplus ions of Si, N,. which are formed by ion implanting Si, N,. into the thin film 105.

Next, a single nucleus of the thin film material is formed on only the hetero material 106 by the proper deposition condition. Namely, the dissimilar material 106 needs to be sufficiently finely formed so that only a single nucleus is formed. Although the size of area of material 106 differs depending on the kind of material, it is sufficient to set the size to a value of a few micrometer or less. Further, the nucleus grows while keeping the monocrystalline structure or (substantially monocrystalline structure) and becomes an island-shaped monocrystal grain 107 as shown in Fig. 5(B). To form the island-shaped monocrystal grain 107, it is desirable to choose the conditions such that a nucleus is rarely if ever formed on the thin film 105 as already mentioned above.

The island-shaped monocrystal grain 107 further grows around the hetero material 106 while keeping the monocrystalline structure (or substantially monocrystalline structure)and covers the whole thin film 105 as shown in Fig. 5(C).

Subsequently, the monocrystal grain 107 is made flat by etching or polishing, thereby forming a monocrystalline layer 108 on the thin film 105, so that a desired device can be formed on the layer 108 as shown in Figs. 5(D) and 6(B).

Practical details are given as follows:

$SiO_2$ is used as the deposition surface material of the thin film 105. This $SiO_2$ film layer may be formed by sputtering, CVD or vacuum deposition etc. On the other hand, although $SiO_2$ is desirable as the material of the deposition surface, it is also possible to use silicon oxide of non-stoichiometric composition.

A silicon nitride layer (in this case, $Si_3N_4$ layer) or a polycrystalline silicon layer is deposited as a dissimilar material on the $SiO_2$ layer 105 by a reduced pressure vapor phase growth method. The silicon nitride layer or polycrystalline silicon layer is patterned by the ordinary lithography technique or a lithography technique using X-rays, electron beam, or ion beam, thereby forming a fine hetero material 106 of a diameter of a few microns or less, preferably, $1\mu m$ or less.

Subsequently, Si is selectively grown on the substrate 11 by use of the mixed gases of HCl, $H_2$, and $SiH_2Cl_2$, $SiCl_4$, $SiHCl_3$, $SiF_4$, or $SiH_4$. The temperature of the substrate at this time falls within a range from 700 to 1000°C and the pressure is about $1.33 \times 10^4$ Pa (100 Torr).

After an elapse of some tens of minutes, the monocrystal silicon grain 107 grows around the fine dissimilar material 106 of silicon nitride or polycrystalline silicon on $SiO_2$. By setting the optimum growth condition the grain 107 grows to a size of tens of $\mu m$ or larger.

Subsequently, by making on Si flat by etching it by a reactive ion etching (RIE) due to the difference of the etching rates between Si and $SiO_2$, a polycrystalline silicon layer of a controlled grain diameter is formed. Further, after eliminating grain boundaries, an island-shaped monocrystalline silicon layer 108 is formed. When the surface roughness of the monocrystal grain 107 is large, it is mechanically polished and thereafter it is etched.

This transistor exhibits characteristics almost the same as those of a similar geometry transistor formed in a monocrystalline silicon wafer.

On the other hand, since the monocrystalline silicon layer 108 is electrically isolated by $SiO_2$ from the adjacent monocrystalline silicon substrate 104, even when complementary field effect transistors (C-MOS) are constituted, they are not interfered. On the other hand, since a thickness of active layer of the device is thinner than that in the case of using an Si wafer per se, malfunction due to charging in the wafer, which is generated in the presence of radiation, does not occur. Further, since the parasitic capacitance decreases, a high operational speed of the device can be realised. In addition, since an arbitrary substrate can be used, a monocrystalline layer can be formed cheaply on a larger area substrate as compared with the case where use is limited to an Si wafer.

(Compositions of silicon nitride)

The material to obtain the sufficient nucleation density difference between the deposition surface material and the dissimilar material as mentioned above is not limited to $Si_3N_4$, but it is also possible to use silicon nitride having a non-stoichiomatic composition.

According to the plasma CVD method whereby a silicon nitride film is formed at low temperatures by dissolving the $SiH_4$ gas and $NH_3$ gas in the RF plasma, by changing the flow rate ratio of the $SiH_4$ gas and $NH_3$ gas, the composition ratio of Si and N in the silicon nitride film to be deposited can be largely changed.

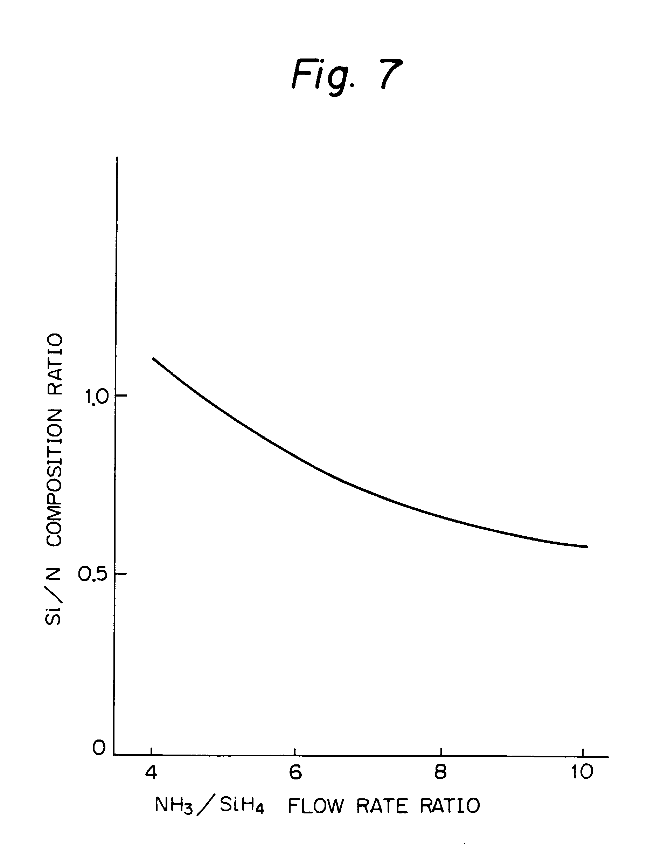

Fig. 7 is a graph showing the relation between the flow rate ratio of $SiH_4$ and $NH_3$ and the composition ratio of Si and N in the silicon nitride film formed.

In the deposition condition at this time, the RF output was 175 W and the substrate temperature was 380°C. The flow rate of the $SiH_4$ gas was fixed to 300 cc/min and the flow rate of the $NH_3$ gas was changed. As shown in this graph, when the gas flow rate ratio of $NH_3/SiH_4$ was changed from 4 to 10, it has been found by an Auger electrospectral method that the Si/N ratio in the silicon nitride film changed from 1.1 to 0.58.

On the other hand, a silicon nitride film was formed by the reduced pressure CVD method by introducing the $SiH_2Cl_2$ gas and the $NH_3$ gas under the conditions of the reduced pressure of 40 Pa (0.3 Torr) and the temperature of about 800°C. The compositions of this silicon nitride film were near $Si_3N_4$ (Si/N = 0.75); the value of this composition ratio is the stoichiometric ratio.

On the other hand, in the case of the silicon nitride film which is formed by heat treating Si in ammonia or $N_2$ at a temperature of about 1200°C (by a heat nitriding process), since it is formed under the thermal equilibrium, the composition ratio which is further close to the stoichiometric ratio can be obtained.

The silicon nitrides formed by the foregoing various kinds of methods were used as the deposition surface materials in which the nucleation density of Si is higher than that on $SiO_2$, and the nucleus of Si was grown. Thus, the difference of the nucleation densities occurs due to the composition ratio.

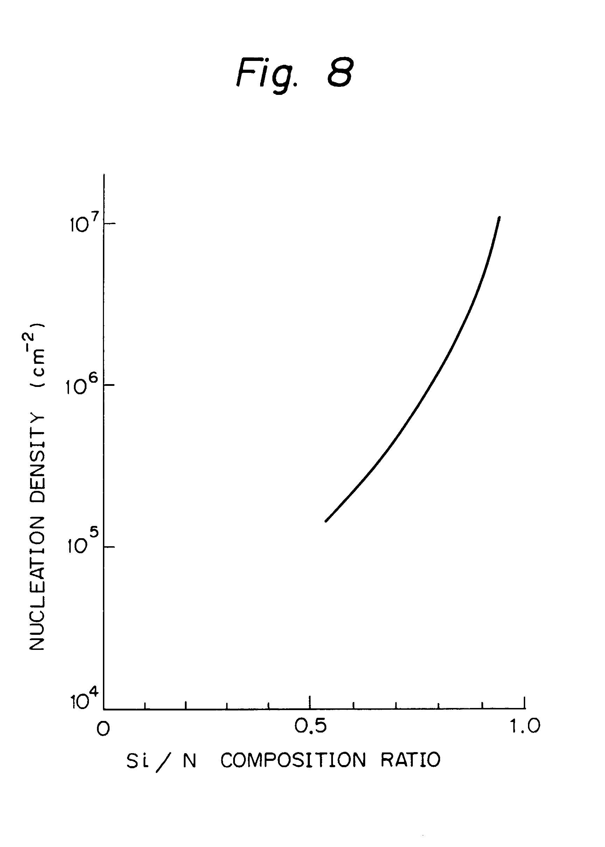

Fig. 8 is a graph showing the relation between the Si/N composition ratio and the nucleation density. As shown in the graph, by changing the compositions of the silicon nitride film, the nucleation density of Si which grows on this film largely changes. In the nucleus forming conditions at this time, the pressure of the $SiCl_4$ gas was reduced to 2.3 x $10^4$ Pa (175 Torr) and Si was produced by reacting with $H_2$ at 1000°C.

In this manner, by exposing, developing, and dissolving the nucleus forming portion due to the compositions of the silicon nitride, the $SiO_2$ surface is partially exposed.

Subsequently, by use of the $SiF_4$ gas as the source gas, the Si ions are implanted into the $SiO_2$ surface at a density within a range from 1 x $10^{16}$ to 1 x $10^{18}$ cm$^{-2}$ at a voltage of 10 keV. The projection range due to this is 11.4nm (114 Å) and the Si concentration on the $SiO_2$ surface reaches a value of $10^{22}$ cm$^{-3}$ or less. Since $SiO_2$ is inherently amorphous, the region into which the Si ions are implanted is also amorphous.

To form the modified region, the ion implantation can be also performed using a resist as a mask. However, the Si ions which were focused without using a resist mask may also be implanted into the $SiO_2$ surface using the focused ion beam technique.

After the ions are implanted in this manner, and after eliminating the resist, a modified region having surplus Si is formed on the $SiO_2$ surface. Then, Si is grown from a vapor phase on the $SiO_2$ deposition surface on which the modified region is formed.

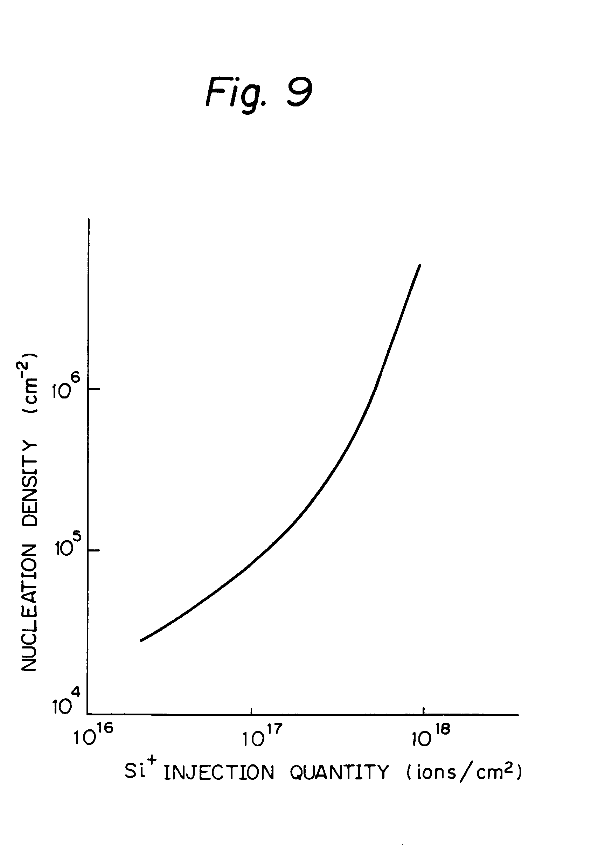

Fig. 9 is a graph showing the relation between the injection quantity of Si ions and the nucleation density.

As shown in the graph, it will be understood that the nucleation density increases as the injection quantity of Si$^+$ ions is increased.

Therefore, by forming a modified region of sufficiently fine area, a single nucleus of Si can be grown using the modified region as a dissimilar material. A monocrystal can be grown as mentioned above.

A modified region of sufficiently fine area can be easily produced by resist patterning or by using a focused ion beam.

(Si deposition method other than the CVD method)

The method of growing a monocrystal by selectively forming a nucleus of Si is not limited to the CVD method. It is also possible to use a method whereby Si is evaporated in a vacuum (less than $10^{-4}$Pa ($10^{-6}$ Torr)) by an electron gun and deposited onto the heated substrate.

In particular, according to the MBE (Molecular Beam Epitaxy) method whereby the evaporation deposition is performed in the ultra-vacuum (less than $10^{-7}$ Pa ($10^{-9}$ Torr)), it is known that $SiO_2$ starts to react on the Si beam at a substrate temperature of 900°C. or more and a nucleus of Si is rarely if ever formed on $SiO_2$ (T Yonehara, S Yoshioka, and S Miyazawa, "Journal of Applied Physics", Vol 53, 10, Page 6839, in 1983).

A single nucleus of Si was perfectly selectively formed on micro silicon nitride which had been formed as a spot on $SiO_2$ by use of the foregoing phenomenon, and a monocrystal of Si could be grown. In the deposition conditions at this time, the vacuum degree was $10^{-6}$ Pa ($10^{-8}$ Torr) or less, the intensity of Si beam was 9.7 x $10^{14}$ atoms/cm$^2$.sec, and the substrate temperature was set to a value within a range from 900 to 1000°C.

In this case, the reactive product of SiO having a remarkably high vapor pressure is formed by the reaction of

$$SiO_2 + Si \rightarrow 2SiO\uparrow$$

$SiO_2$ itself is etched by Si due to the evaporation.

On the other hand, the foregoing etching phenomenon does not occur on silicon nitride but a nucleus is formed and deposited.

Similar effects can be also obtained by using other deposition surface material having a high nucleation density such as tantalum oxide ($Ta_2O_5$) silicon nitride oxide (SiON) as well as silicon nitride.

## Claims

1. A method of fabricating a complementary MOS transistor which method comprises:

   providing a monocrystalline silicon semiconductor substrate (1) having a first MOS transistor (2) of a first channel conductivity type defined at the surface thereof, which transistor (2) is isolated by a surrounding region (10) of field oxide;
   covering said first MOS transistor (2) with a layer (18) of silicon dioxide;
   producing a silicon monocrystal on said layer (18) of silicon dioxide; and
   producing a second MOS transistor (3) of a second and complementary channel conductivity type at the surface of said silicon monocrystal;

   characterised in that to produce said silicon monocrystal the following steps are performed:

   producing a nucleation site (17) of size a few µm or less consisting of silicon nitride, silicon oxynitride or tantalum oxide on said layer (18) of silicon dioxide or consisting of a region of said layer (18) of silicon dioxide implanted with ions of nitrogen or excess ions of silicon; and depositing silicon thereby growing a single nucleus of silicon selectively on said nucleation site (17), and growing said silicon monocrystal from said single nucleus.

## Revendications

1. Procédé de fabrication d'un transistor à structure MOS complémentaire, lequel procédé comprend :

   l'utilisation d'un substrat semiconducteur (1) en silicium monocristallin ayant un premier transistor MOS (2) d'un premier type de conductivité de canal défini à sa surface, lequel transistor (2) est isolé par une région entourante (10) d'oxyde épais ;
   le recouvrement dudit premier transistor MOS (2) avec une couche (18) de dioxyde de silicium ;
   la production d'un monocristal de silicium sur ladite couche (18) de dioxyde de silicium ; et
   la production d'un second transistor MOS (3) d'un second type, complémentaire, de conductivité de canal à la surface dudit monocristal de silicium ;

   caractérisé en ce que, pour produire ledit monocristal de silicium, on exécute les étapes suivantes :

   la production d'un site (17) de germination d'une dimension de quelques µm ou moins, constitué de nitrure de silicium, d'oxynitrure de silicium ou d'oxyde de tantale, sur ladite couche (18) de dioxyde de silicium, ou constitué d'une région de ladite couche (18) d'oxyde de silicium dans laquelle sont implantés des ions azote ou des ions silicium excédentaires ; et
   le dépôt de silicium pour ainsi faire croître un germe unique de silicium sélectivement sur ledit site de germination (17) et faire croître ledit monocristal de silicium à partir dudit germe unique.

## Patentansprüche

1. Verfahren zur Herstellung eines MOS-Komplementärtransistors, wobei das Verfahren die nachstehenden Schritte umfaßt:

   Bereitstellung eines einkristallinen Siliciumhalbleitersubstrats (1) mit einem auf seiner Oberfläche ausgebildeten ersten MOS-Transistor (2) eines ersten Kanalleitungstyps, wobei der Transistor (2) durch einen Umgebungsbereich (10) aus Feldoxid isoliert ist;

Bedecken des ersten MOS-Transistors (2) mit einer Schicht (18) aus Siliciumdioxid;

Erzeugung eines Siliciumeinkristalls auf der Schicht (18) aus Siliciumdioxid; und

Erzeugung eines zweiten MOS-Transistors (3) eines zweiten und komplementären Kanalleitungstyps auf der Oberfläche des Siliciumeinkristalls;

**dadurch gekennzeichnet, daß**

zur Erzeugung des Siliciumeinkristalls die nachstehenden Schritte durchgeführt werden:

Erzeugung eines Kristallisationszentrums (17) mit einer Größe von einigen µm oder weniger, das aus Siliciumnitrid, Siliciumoxynitrid oder Tantaloxid besteht, auf der Schicht (18) aus Siliciumdioxid, oder das aus einem Bereich der Schicht (18) aus Siliciumdioxid, in den Stickstoffionen oder überschüssige Siliciumionen implantiert wurden, besteht; und

Abscheidung von Silicium unter selektiver Züchtung eines einzelnen Siliciumkristallkeims auf dem Kristallisationszentrum (17) und Züchten des Siliciumeinkristalls aus dem einzelnen Kristallkeim.

# Fig. 1

# Fig. 2

# Fig. 3

(A)

102

101

(B)

103

102

101

# Fig. 4

# *Fig. 5*

( A )

( B )

( C )

( D )

# Fig. 6

(A)

(B)

# Fig. 7

# Fig. 8

# Fig. 9